# EUROPÄISCHE PATENTSCHRIFT

(11) **EP 3 308 405 B1**
(45) Veröffentlichungstag und Bekanntmachung des Hinweises auf die Patenterteilung: **18.12.2024**
(21) Anmeldenummer: 16729834.8
(22) Anmeldetag: 07.06.2016
(51) Int. Cl.: H01L 31/101, H01L 27/144, H01L 31/12

(54) **BAUTEIL ZUM DETEKTIEREN ELEKTROMAGNETISCHER STRAHLUNG**
DEVICE FOR THE DETECTION OF ELECTROMAGNETIC RADIATION
DISPOSITIF POUR LA DÉTECTION DES RAYONNEMENTS ÉLECTROMAGNÉTIQUES

(30) Priorität: 09.06.2015 DE 102015109044
(43) Veröffentlichungstag der Anmeldung: 18.04.2018
(73) Patentinhaber: Fraunhofer-Gesellschaft zur Förderung der angewandten Forschung e.V., 80686 München (DE)
(72) Erfinder: RICHTER, Bernd, 01159 Dresden (DE); WARTENBERG, Philipp, 01097 Dresden (DE); FEHSE, Karsten, 01109 Dresden (DE); JAHNEL, Matthias, 01159 Dresden (DE)
(86) Internationale Anmeldenummer: PCT/EP2016/062865
(87) Internationale Veröffentlichungsnummer: WO 2016/198382

(56) Entgegenhaltungen:
- US-A1- 2003 209 651
- US-A1- 2007 029 482
- US-A1- 2008 179 520
- US-A1- 2013 147 764
- US-A1- 2015 108 508
- BERND RICHTER ET AL: "Bidirectional OLED microdisplay: Combining display and image sensor functionality into a monolithic CMOS chip", SOLID-STATE CIRCUITS CONFERENCE DIGEST OF TECHNICAL PAPERS (ISSCC), 2011 IEEE INTERNATIONAL, IEEE, 20 February 2011 (2011-02-20), pages 314 - 316, XP032013753, ISBN: 978-1-61284-303-2, DOI: 10.1109/ISSCC.2011.5746334

## Beschreibung

Die Erfindung betrifft Bauteile zum Detektieren elektromagnetischer Strahlung, mit denen sowohl multispektrale Sensoren als auch Sensor-Emitter-Systeme realisiert werden können. Unter einem multispektralen Sensor soll ein Bauteil verstanden werden, mit welchem elektromagnetische Strahlung aus mindestens zwei unterschiedlichen Wellenlängenbereichen detektiert werden kann und unter einem Sensor-Emitter-System soll ein Bauteil verstanden werden, welches sowohl mindestens ein elektromagnetische Strahlung detektierendes Element als auch mindestens ein elektromagnetische Strahlung emittierendes Element umfasst.

Ein Bolometer auf einem Substrat mit einem Emitter auf der anderen Seite des Substrats ist aus US 2007/0029482 A1 bekannt.

Ein Bauteil, mittels dessen elektromagnetische Strahlung verschiedener Wellenlängenbereiche detektiert werden kann, ist aus US 2003/209651 A1 bekannt. Nachteilig wirkt sich hierbei aus, dass ein solches Bauteil nicht als Sensor-Emitter-System verwendet werden kann.

DE 10 2006 030 541 A1 und US 2015/108508 A1 beschreiben Sensor-Emitter-Systeme, bei denen sich elektromagnetische Strahlung emittierende Elemente und elektromagnetische Strahlung detektierende Elemente gemeinsam nebeneinander auf einem Chip befinden. Dabei können beide Elementarten in einer Matrix auf dem Chip angeordnet sein. Nachteilig wirkt sich hierbei aus, dass die unmittelbar angrenzende Anordnung von elektromagnetische Strahlung emittierenden Elementen und elektromagnetische Strahlung detektierenden Elementen zum Überkoppeln führt.

Aus WO 2012/163312 A1 und BERND RICHTER ET AL: "Bidirectional OLED microdisplay: Combining display and image sensor functionality into a monolithic CMOS chip", SOID-STATE CIRCUITS CONFERENCE DIGEST OF TECHNICAL PAPERS (ISSCC), 2011, IEEE, Seiten 314 - 316, sind bidirektionale Displays bekannt, auf denen mehrere lichterzeugende Bildelemente und mehrere lichterfassende Elemente in Form eines Arrays angeordnet sind. Dabei können die lichterzeugenden Bildelemente in ihrer Gesamtheit beispielsweise als Anzeigefläche eines Displays und die lichterfassenden Elemente in ihrer Gesamtheit beispielsweise als Sensor einer Kamera fungieren. WO 2012/163312 A1 beschreibt ferner verschiedene Ansteuervarianten der Elemente, die das Problem des direkten Übersprechens von lichterzeugenden Bildelementen auf angrenzende lichterfassende Elemente lösen sollen, indem die lichterzeugenden Bildelemente und angrenzende lichterfassende Elemente nacheinander angesteuert werden. Dadurch sind lichterzeugende Bildelemente und angrenzende lichterfassende Elemente nur abwechselnd nacheinander aktiv wirksam.

Fungieren die lichterzeugenden Bildelemente einer bidirektionalen Vorrichtung als Display, stoßen die in WO 2012/163312 A1 offenbarten Ansteuervarianten an ihre Grenzen.

Insbesondere die Inaktivität der lichterzeugenden Bildelemente während einer Belichtungszeit von lichterfassenden Elementen, die für eine gute Signalqualität eine bestimmte Länge erfordert, kann zu wahrnehmbaren Bildstörungen, mindestens aber zu einem sichtbaren Helligkeitsverlust führen. Die Sensitivität der Detektorelemente wiederum kann nicht beliebig gesteigert werden, da bei Displayanwendungen immer höhere Auflösungen gefordert werden, wobei die verwendete Chipfläche aus Kostengründen möglichst gering bleiben soll, so dass damit der Platz für Detektorelemente bzw. schaltungstechnische Maßnahmen zum Steigern derer Sensitivität stark eingeschränkt sind.

Ein weiteres Problem bekannter Sensor-Emitter-Systeme, bei denen Strahlung detektierende Elemente und Strahlung emittierende Elemente nebeneinander angeordnet sind, stellt der geringe Füllgrad bezüglich der beiden Funktionen dar. D.h., sowohl für das Detektieren als auch für das Emittieren von Strahlung steht nur ein relativ geringer Oberflächenbereich eines solchen Sensor-Emitter-Systems zur Verfügung, weil die anderen Oberflächenbereiche durch Elemente der jeweils anderen Funktion bzw. durch Flächenbereiche, die für das Verdrahten der Elemente benötigt werden, bedeckt sind.

Der Erfindung liegt daher das technische Problem zugrunde, ein Bauteil zu schaffen, mit dem die Nachteile aus dem Stand der Technik überwunden werden können. Insbesondere sollen sich mit einem erfindungsgemäßen Bauteil multispektrale Sensoren realisieren lassen, mittels denen elektromagnetische Strahlung unterschiedlicher Wellenlängenbereiche detektierbar ist als auch Sensor-Emitter-Systeme, die einen hohen Füllgrad bezüglich der Funktion des Detektierens als auch bezüglich der Funktion des Emittierens elektromagnetischer Strahlung aufweisen.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Ansprüchen.

Bei einem erfindungsgemäßen Bauteil sind die Elemente, die Funktionen des Detektierens oder des Emittierens elektromagnetischer Strahlung realisieren nicht nebeneinander innerhalb einer Schicht angeordnet, sondern für alle Elemente die ein und dieselbe Funktion realisieren, ist jeweils eine separate Funktionsschicht ausgebildet, wobei die einzelnen Funktionsschichten übereinander liegend angeordnet sind. Auf diese Weise kann für die Elemente, die eine Funktion realisieren, ein gegenüber dem Stand der Technik erhöhter Füllgrad erzielt werden.

Ein erfindungsgemäßes Bauteil umfasst daher eine erste Funktionsschicht, innerhalb der eine Vielzahl erster Elemente ausgebildet ist, mittels dem elektromagnetische Strahlung aus einem ersten Wellenlängenbereich detektierbar ist, wobei die erste Funktionsschicht auf einer Seite eines Substrates abgeschieden ist. Bevorzugt weist die erste Funktionsschicht eine Vielzahl von elektromagnetische Strahlung detektierenden ersten Elementen auf, die vorzugsweise rasterförmig über die erste Funktionsschicht verteilt angeordnet sind. Als Detektorelement sind alle Bauelemente geeignet, die innerhalb einer Funktionsschicht ausgebildet werden können und mit denen elektromagnetische Strahlung detektierbar ist. So kann ein Detektorelement beispielsweise als Fotodiode oder als Foto-Feldeffekttransistor ausgebildet sein. Mit diesen Detektorelementen der ersten Funktionsschicht kann beispielsweise elektromagnetische Strahlung aus dem Bereich der Infrarotstrahlung, dem Bereich der Strahlung, der mit einem menschlichen Auge erfassbar ist, dem Bereich der Röntgenstrahlung oder aus dem Bereich der Ultraviolettstrahlung erfasst werden. Ein erfindungsgemäßes Bauteil umfasst außerdem eine zweite Funktionsschicht, innerhalb der eine Vielzahl zweiter Elemente ausgebildet ist, mittels der zweiter Elemente elektromagnetische Strahlung aus einem zweiten Wellenlängenbereich emittierbar. Dabei ist die zweite Funktionsschicht auf der Seite des Substrates abgeschieden, die der ersten Funktionsschicht gegenüber liegt. Die zweite Funktionsschicht weist eine Vielzahl von zweiten Elementen auf, die alle eine elektronmagnetische Strahlung emittierende Funktion ausführen. Auch die Vielzahl zweiter Elemente ist vorzugsweise rasterförmig über die Fläche der zweiten Funktionsschicht verteilt angeordnet. Der zweite Wellenlängenbereich kann beispielsweise aus dem Bereich der Infrarotstrahlung, dem Bereich der Strahlung, der mit einem menschlichen Auge erfassbar ist, dem Bereich der Röntgenstrahlung oder aus dem Bereich der Ultraviolettstrahlung ausgewählt sein.

Eine Funktionsschicht, die elektromagnetische Strahlung detektierende Elemente umfasst, wird nachfolgend auch als Detektor-Schicht oder verkürzt als Detektor bezeichnet und eine Funktionsschicht, welche elektrische Strahlung emittierende Elemente umfasst, als Emitter-Schicht oder verkürzt als Emitter.

Wenn die erste Funktionsschicht und die zweite Funktionsschicht jeweils als Detektor ausgebildet sind, unterscheidet sich der erste Wellenlängenbereich vorzugsweise vom zweiten Wellenlängenbereich. Mittels eines solchen erfindungsgemäßen Bauteils kann dann elektromagnetische Strahlung, die von der Seite der ersten Funktionsschicht auf das Bauteil einfällt, in zwei verschiedenen Wellenlängenbereichen detektiert werden.

Bevorzugt bestehen die erste Funktionsschicht und die zweite Funktionsschicht aus einem organischen Material. Verfahrensschritte zum Ausbilden von Elementen (innerhalb einer organischen Schicht) mit denen elektromagnetische Strahlung detektiert oder elektromagnetische Strahlung emittiert werden kann, sind bekannt. Bei einer Ausführungsform umfasst das organische Material, aus welchem die erste Funktionsschicht und/oder die zweite Funktionsschicht besteht, auch noch Nanopartikel, welche innerhalb des organischen Materials eingelagert sind. Derartige Nanopartikel können beispielsweise als sogenannte Quantum-Nanopartikel (auch als Quantum-Nano-Dots oder verkürzt als QND bezeichnet) ausgebildet sein. Als Substratmaterial sind Kunststoffe oder Gläser geeignet. Bevorzugt wird jedoch als Substrat eines erfindungsgemäßen Bauteils ein Halbleitersubstrat (beispielsweise ein Siliziumsubstrat) verwendet.

Bei einer Ausführungsform sind innerhalb des Substrats eine Schaltungsstruktur, bestehend aus aktiven Bauelementen (wie beispielsweise eine CMOS-Struktur) sowie mindestens eine Verbindungsebene, bestehend aus einer Vielzahl von Leiterbahnen, ausgebildet. Ebenfalls weist das Halbleitersubstrat mindestens eine Durchkontaktierung auf, mittels der ein Detektorelement oder ein Emitterelement aus einer Funktionsschicht mit einer Leiterbahn der Verbindungsebene innerhalb des Substrates elektrisch leitend verbunden ist.

Die vorliegende Erfindung wird nachfolgend anhand von Ausführungsbeispielen näher erläutert. Die Fig. zeigen:
- Fig. 1: eine schematische Schnittdarstellung des Aufbaus eines nicht erfindungsgemäßen Bauteils mit zwei Detektoren;
- Fig. 2: eine schematische Schnittdarstellung des Aufbaus eines nicht erfindungsgemäßen Bauteils mit zwei Detektoren und einem als Detektor ausgebildeten Substrat;
- Fig. 3: eine schematische Schnittdarstellung des Aufbaus eines nicht erfindungsgemäßen Bauteils mit einem Detektor und einem Emitter;
- Fig. 4: eine schematische Schnittdarstellung des Aufbaus eines erfindungsgemäßen Bauteils mit einem Detektor und einem Emitter sowie einem als Detektor ausgebildetem Substrat.

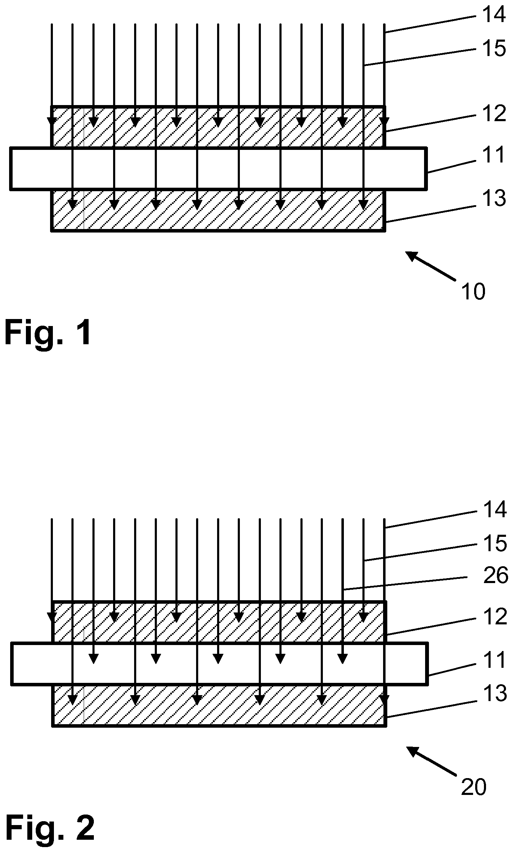

In Fig. 1 ist ein nicht erfindungsgemäßes Bauteil 10 in einem Schnitt schematisch dargestellt. Das Bauteil 10 umfasst ein Substrat 11, auf dessen einen Seite eine erste Funktionsschicht 12 und auf dessen anderen Seite eine zweite Funktionsschicht 13 abgeschieden sind. Beide Funktionsschichten 12 und 13 bestehen aus einem organischen Material. Innerhalb der Funktionsschicht 12 ist eine Vielzahl von in Fig. 1 nicht dargestellten ersten Fotodioden ausgebildet, die rasterförmig über die Fläche der Funktionsschicht 12 verteilt angeordnet sind und mittels denen elektromagnetische Strahlung 14 aus einem ersten Wellenlängenbereich, wie beispielsweise dem Ultraviolett-Wellenlängenbereich, detektierbar ist. Die Funktionsschicht 12 ist somit als Detektor für UV-Strahlung ausgebildet.

Innerhalb der Funktionsschicht 13 ist eine Vielzahl von in Fig. 1 ebenfalls nicht dargestellten zweiten Fotodioden ausgebildet, die rasterförmig über die Fläche der Funktionsschicht 13 verteilt angeordnet sind und mittels denen elektromagnetische Strahlung 15 aus einem zweiten Wellenlängenbereich, wie beispielsweise dem Infrarot-Wellenlängenbereich, detektierbar ist. Die Funktionsschicht 13 ist somit ebenfalls als Detektor aber diesmal für IR-Strahlung ausgebildet. Das Substrat 11 und die Funktionsschicht 12 sind außerdem transparent gegenüber IR-Strahlung. Mit dem Bauteil 10 kann somit sowohl UV-Strahlung als auch IR-Strahlung detektiert werden, die von der Seite der Funktionsschicht 12 auf das Bauteil 10 einstrahlt.

Das Substrat 11 besteht aus einem Siliziummaterial, das bereits eine CMOS-Struktur und somit eine Logikschaltung umfasst, welche für das Ansteuern der innerhalb der Funktionsschichten 11 und 12 ausgebildeten Fotodioden verwendet wird. Auf der Seite des Substrates 11, die an die Funktionsschicht 12 angrenzt, ist eine in Fig. 1 ebenso nicht dargestellte Verdrahtungsebene ausgebildet, mit deren Leiterbahnen die Kontakte der in den Funktionsschichten ausgebildeten Fotodioden verschaltet werden. Dabei sind die in der Funktionsschicht 12 ausgebildeten Fotodioden direkt mit den angrenzenden Leiterbahnen der Verdrahtungsebene kontaktiert, während die innerhalb der Funktionsschicht 13 ausgebildeten Fotodioden mittels sogenannter Through-Silicon-Vias (nachfolgend als "TSVs" bezeichnet) durch das Substrat 11 hindurch mit den Leiterbahnen der Verdrahtungsebene kontaktiert sind. Der Vollständigkeit halber sei erwähnt, dass Verfahrensschritte zum Ausbilden einer Schaltungsstruktur aus aktiven Bauelementen und einer Verdrahtungsebene innerhalb eines Substrates aus einem Halbleitermaterial sowie Verfahrensschritte zum Ausbilden von Kontaktierungen durch ein solches Substrat hindurch bekannt sind.

Das Verwenden der Verdrahtungsebene eines Substrates für das Verschalten von Fotodioden innerhalb übereinander angeordneter Funktionsschichten ermöglicht einen hohen Füllfaktor einer jeden Funktionsschicht mit elektromagnetische Strahlung detektierenden Elementen gegenüber bekannten optoelektronischen Bauteilen, bei denen die Verdrahtung innerhalb der Funktionsschicht selbst erfolgt. Mit dem Bauteil 10 wurde somit ein multispektraler Sensor mit einem gegenüber dem Stand der Technik erhöhten Auflösungsgrad realisiert.

Fig. 2 zeigt einen alternativen multispektralen Sensor 20, der zunächst alle Merkmale des multispektralen Sensors 10 aus Fig. 1 aufweist. Zusätzlich sind jedoch beim multispektralen Sensor 20 innerhalb des Substrates 11 eine Vielzahl von in Fig. 2 nicht dargestellten dritten Fotodioden ausgebildet, die rasterförmig über die Fläche des Substrates 11 verteilt angeordnet sind und mittels denen elektromagnetische Strahlung 26 aus dem Wellenlängenbereich, der mit einem menschlichen Auge erfasst werden kann, detektierbar ist. Das Substrat 11 ist somit auch noch als Detektor für elektromagnetische Strahlung aus einem dritten Wellenlängenbereich ausgebildet. Verfahrensschritte für das Ausbilden von Fotodioden innerhalb eines Halbleitersubstrates sind ebenfalls bekannt. Die Verschaltung der dritten Fotodioden innerhalb des Substrates 11 erfolgt ebenfalls mittels der Verdrahtungsebene, die an einer Seite des Substrates 11 ausgebildet ist, wie es bereits zu Fig. 1 beschrieben wurde. Mit einem multispektralen Sensor 20 können somit elektromagnetische Strahlen dreier verschiedener Wellenlängenbereiche detektiert werden, die von der Seite das Bauteil 20 beaufschlagen, an welcher die Funktionsschicht 12 abgeschieden ist. Hierfür ist es zusätzlich noch erforderlich, dass die Funktionsschicht 12 transparent gegenüber der elektromagnetischen Strahlung ausgebildet ist, die mit den dritten Fotodioden innerhalb des Substrates 11 detektiert wird.

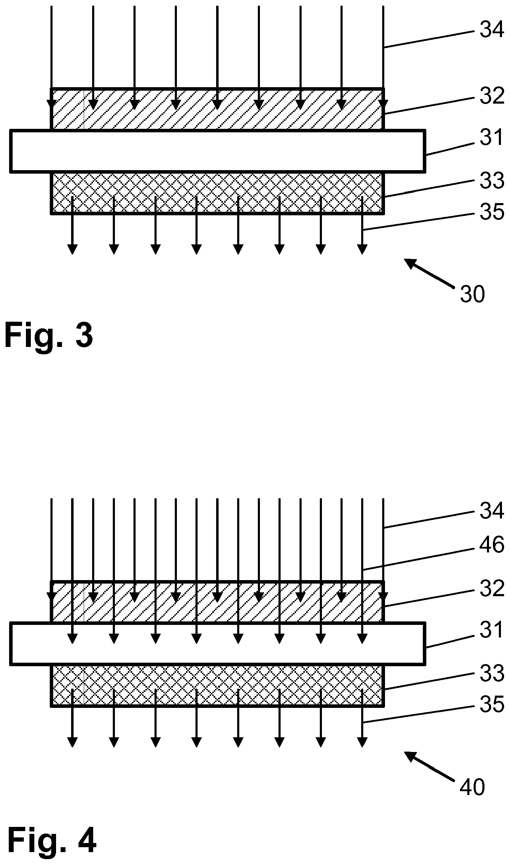

In Fig. 3 ist ein weiteres alternatives nicht erfindungsgemäßes Bauteil 30 schematisch dargestellt, welches als Sensor-Emitter-System ausgebildet ist. Das Bauteil 30 umfasst ein Substrat 31 aus einem Halbleitermaterial auf Siliziumbasis, innerhalb dem bereits eine CMOS-Struktur, eine Verdrahtungsebene und TSVs-Durchkontaktierungen ausgebildet sind, so wie es zu Substrat 11 aus Fig. 1 beschrieben wurde. Auf einer Seite des Substrates 31 ist eine erste Funktionsschicht 32 aus einem organischen Material abgeschieden, innerhalb der eine Vielzahl von in Fig. 3 nicht dargestellten ersten Fotodioden ausgebildet sind, die rasterförmig über die Fläche der Funktionsschicht 32 verteilt angeordnet sind und mittels denen elektromagnetische Strahlung 34 aus einem ersten Wellenlängenbereich, wie beispielsweise dem Infrarot-Wellenlängenbereich detektierbar ist. Die Funktionsschicht 32 ist somit als Detektor für IR-Strahlung ausgebildet. Die Fotodioden innerhalb der Funktionsschicht 32 sind mit den Leiterbahnen der Verdrahtungsebene des Substrates 31 kontaktiert und werden mittels der innerhalb des Substrates 31 ausgebildeten CMOS-Schaltung angesteuert.

Auf der anderen Seite des Substrates 31 ist eine zweite Funktionsschicht 33 aus einem organischen Material abgeschieden. Innerhalb der Funktionsschicht 33 ist eine Vielzahl von in Fig. 1 nicht dargestellter Leuchtdioden ausgebildet, die rasterförmig über die Fläche der Funktionsschicht 12 verteilt angeordnet sind und mittels denen elektromagnetische Strahlung 35 dem Wellenlängenbereich, der mit einem menschlichen Auge erfassbar ist, emittiert. Die Funktionsschicht 33 ist somit als Emitter ausgebildet. Mittels den im Substrat 31 ausgebildeten TSVs werden die Leuchtdioden der Funktionsschicht 33 mit den Leiterzügen der Verdrahtungsebene kontaktiert und über die CMOS-Schaltung im Substrat 31 angesteuert. Das Sensor-Emitter-System 30 kann beispielsweise als Bildwandler in Nachtsichtgeräten verwendet werden, indem die Daten des mit dem Sensor 32 detektierten IR-Strahlungsbildes mit der CMOS-Schaltung im Substrat 31 ausgewertet werden und auf dem Emitter 33 ein Strahlungsbild wiedergegeben wird, dass mit einem menschlichen Auge erfasst werden kann.

Ein alternatives Sensor-Emitter-System 40 ist in Fig. 4 schematisch dargestellt, das zunächst alle Merkmale des Sensor-Emitter-Systems 30 aus Fig. 3 aufweist. Zusätzlich ist jedoch beim Sensor-Emitter-System 40 innerhalb des Substrates 31 eine Vielzahl von in Fig. 4 nicht dargestellten dritten Fotodioden ausgebildet, die rasterförmig über die Fläche des Substrates 31 verteilt angeordnet sind und mittels denen elektromagnetische Strahlung 46 aus dem Ultraviolett-Wellenlängenbereich detektierbar ist. Das Substrat 31 ist somit auch noch als Detektor für elektromagnetische Strahlung aus dem UV-Wellenlängenbereich ausgebildet. Das Verschalten der dritten Fotodioden innerhalb des Substrates 31 erfolgt mittels der Verdrahtungsebene, die an einer Seite des Substrates 31 ausgebildet ist. Mit einem erfindungsgemäßen Sensor-Emitter-System, gemäß Fig. 4, lassen sich somit Strahlungsbilder aus zwei unterschiedlichen Wellenlängenbereichen mittels der Detektoren 31 und 32 erfassen und können separat oder auch akkumuliert als Strahlungsbild in einem dritten Wellenlängenbereich mittels des Emitters 33 wiedergegeben werden.

Es sei angemerkt, dass die in den Fig. 1 bis 4 genannten und den einzelnen Detektoren und Emittern zugeordneten Wellenlängenbereiche bezüglich elektromagnetischer Strahlung nur beispielhaft genannt wurden. Den einzelnen Detektoren und Emittern kann aber auch jeder andere beliebige Wellenlängenbereich elektromagnetischer Strahlung zugeordnet werden, der mit bekannten Sensoren detektiert bzw. mit bekannten Emittern emittiert werden kann.

## Patentansprüche

1. Bauteil (40), umfassend eine erste Funktionsschicht (32), innerhalb der eine Vielzahl als Fotodiode oder Foto-Feldeffekttransistor fungierender erster Elemente ausgebildet ist, mittels der auf die Oberfläche der ersten Funktionsschicht (32) auftreffende elektromagnetische Strahlung (34) aus einem ersten Wellenlängenbereich detektierbar ist, wobei die erste Funktionsschicht (32) auf einer Seite eines aus einem Halbleitermaterial bestehenden und eine Schaltungsstruktur aus aktiven Bauelementen umfassenden Substrates (31) abgeschieden ist, wobei auf der Seite des Substrates (31), welche der ersten Funktionsschicht (32) gegenüberliegt, eine zweite Funktionsschicht (33) abgeschieden ist, innerhalb der eine Vielzahl zweiter Elemente ausgebildet ist, mittels der elektromagnetische Strahlung (35) aus einem zweiten Wellenlängenbereich emittierbar ist, wobei sich der erste Wellenlängenbereich vom zweiten Wellenlängenbereich unterscheidet, **dadurch gekennzeichnet, dass** innerhalb des Substrates (31) eine Vielzahl als Fotodiode ausgebildeter dritter Elemente ausgebildet ist, mittels der auf die Oberfläche der ersten Funktionsschicht (32) auftreffende elektromagnetische Strahlung (46) aus einem dritten Wellenlängenbereich detektierbar ist, wobei sich der dritte Wellenlängenbereich vom ersten und zweiten Wellenlängenbereich unterscheidet und die erste Funktionsschicht (32) transparent bezüglich elektromagnetischer Strahlung (46) aus dem dritten Wellenlängenbereich ist, so dass Strahlungsbilder aus dem ersten Wellenlängenbereich und dem dritten Wellenlängenbereich mittels der ersten Elemente und der dritten Elemente erfassbar sind und separat oder akkumuliert als Strahlungsbild im zweiten Wellenlängenbereich mittels der zweiten Elemente wiedergegeben werden können.

2. Bauteil nach Anspruch 1, **dadurch gekennzeichnet, dass** das Substrat (31) mindestens eine Verdrahtungsebene umfasst.

3. Bauteil nach einem der vorhergehenden Ansprüche, **dadurch gekennzeichnet, dass** das Substrat (31) mindestens eine Durchkontaktierung aufweist.

4. Bauteil nach einem der vorhergehenden Ansprüche, **dadurch gekennzeichnet, dass** innerhalb der ersten Funktionsschicht (32), innerhalb der zweiten Funktionsschicht (33) und/oder innerhalb des Substrates (31) eine Vielzahl von jeweils zugehörigen ersten Elementen, zweiten Elementen bzw. dritten Elementen ausgebildet sind, die über die Fläche der jeweiligen Funktionsschicht (32; 33) bzw. über die Fläche des Substrates (31) verteilt rasterförmig angeordnet sind.

5. Bauteil nach einem der vorhergehenden Ansprüche, **dadurch gekennzeichnet, dass** die erste Funktionsschicht (32) und/oder die zweite Funktionsschicht (33) ein organisches Material umfassen.

6. Bauteil nach Anspruch 5, **dadurch gekennzeichnet, dass** die erste Funktionsschicht (32) und/oder die zweite Funktionsschicht (33) Nanopartikel umfasst.

## Claims

1. Component (40), comprising a first functional layer (32), within which are formed a multiplicity of first elements which function as photodiode or photo-field effect transistor and by means of which electromagnetic radiation (34) from a first wavelength range that is incident on the surface of the first functional layer (32) is detectable, wherein the first functional layer (32) is deposited on a side of a substrate (31) consisting of a semiconductor material and comprising a circuit structure composed of active component elements, wherein a second functional layer (33) is deposited on the side of the substrate (31) which is opposite the first functional layer (32), within which second functional layer are formed a multiplicity of second elements, by means of which electromagnetic radiation (35) from a second wavelength range is emittable, wherein the first wavelength range is different from the second wavelength range, **characterized in that** a multiplicity of third elements formed as photodiode are formed within the substrate (31), by means of which third elements electromagnetic radiation (46) from a third wavelength range that is incident on the surface of the first functional layer (32) is detectable, wherein the third wavelength range is different from the first and second wavelength ranges and the first functional layer (32) is transparent with respect to electromagnetic radiation (46) from the third wavelength range, such that radiation images from the first wavelength range and the third wavelength range are capturable by means of the first elements and the third elements and can be reproduced separately or cumulatively as a radiation image in the second wavelength range by means of the second elements.

2. Component according to Claim 1, **characterized in that** the substrate (31) comprises at least one wiring level.

3. Component according to either of the preceding claims, **characterized in that** the substrate (31) has at least one via.

4. Component according to any of the preceding claims, **characterized in that** within the first functional layer (32), within the second functional layer (33) and/or within the substrate (31) a multiplicity of respectively associated first elements, second elements and/or third elements are formed which are arranged in grid form distributed over the area of the respective functional layer (32; 33) and/or over the area of the substrate (31) .

5. Component according to any of the preceding claims, **characterized in that** the first functional layer (32) and/or the second functional layer (33) comprise(s) an organic material.

6. Component according to Claim 5, **characterized in that** the first functional layer (32) and/or the second functional layer (33) comprise(s) nanoparticles.

## Revendications

1. Composant (40), comprenant une première couche fonctionnelle (32), à l'intérieur de laquelle sont formés un grand nombre de premiers éléments fonctionnant comme une photodiode ou un phototransistor à effet de champ, permettant de détecter un rayonnement électromagnétique (34) d'une première gamme de longueurs d'onde, incident à la surface de la première couche fonctionnelle (32), la première couche fonctionnelle (32) étant déposée sur un côté d'un substrat (31) qui comprend une matière semi-conductrice et une structure de circuit comportant des éléments structurels actifs, une deuxième couche fonctionnelle (33), à l'intérieur de laquelle sont formés un grand nombre de deuxièmes éléments permettant d'émettre un rayonnement électromagnétique (35) d'une deuxième gamme de longueurs d'onde, étant déposée sur le côté du substrat (31) qui est opposé à la première couche fonctionnelle (32), la première gamme de longueurs d'onde différant de la deuxième gamme de longueurs d'onde, **caractérisé en ce qu'**un grand nombre de troisièmes éléments conçus comme des photodiodes, permettant de détecter un rayonnement électromagnétique (46) d'une troisième gamme de longueurs d'onde, incident à la surface de la première couche fonctionnelle (32), sont formés à l'intérieur du substrat (31), la troisième gamme de longueurs d'onde différant des première et deuxième gammes de longueurs d'onde et la première couche fonctionnelle (32) étant transparente au rayonnement électromagnétique (46) de la troisième gamme de longueurs d'onde, de sorte que des images de rayonnement de la première gamme de longueurs d'onde et de la troisième gamme de longueurs d'onde puissent être acquises au moyen des premiers éléments et des troisièmes éléments et puissent être reproduites de manière séparée ou accumulée sous la forme d'une image de rayonnement dans la deuxième gamme de longueurs d'onde au moyen des deuxièmes éléments.

2. Composant selon la revendication 1, **caractérisé en ce que** le substrat (31) comprend au moins un niveau de câblage.

3. Composant selon l'une des revendications précédentes, **caractérisé en ce que** le substrat (31) présente au moins un trou métallisé.

4. Composant selon l'une des revendications précédentes, **caractérisé en ce qu'**à l'intérieur de la première couche fonctionnelle (32), de la deuxième couche fonctionnelle (33) et/ou du substrat (31) sont formés un grand nombre de premiers éléments, deuxièmes éléments ou troisièmes éléments respectivement associés qui sont disposés sous forme de trame de manière répartie sur la surface de la couche fonctionnelle respective (32 ; 33) ou sur la surface du substrat (31) .

5. Composant selon l'une des revendications précédentes, **caractérisé en ce que** la première couche fonctionnelle (32) et/ou la deuxième couche fonctionnelle (33) comprennent une matière organique.

6. Composant selon la revendication 5, **caractérisé en ce que** la première couche fonctionnelle (32) et/ou la deuxième couche fonctionnelle (33) comprennent des nanoparticules.
